# EUROPEAN PATENT APPLICATION

(11) **EP 3 324 432 A1**
(43) Date of publication of application: **23.05.2018**
(21) Application number: 16199245.8
(22) Date of filing: 17.11.2016
(51) Int. Cl.: H01L 23/48, H01H 1/06

(54) **METHOD OF ELECTRICALLY CONTACTING A PLURALITY OF SEMICONDUCTOR CHIPS**

(71) Applicant: Infineon Technologies AG, 85579 Neubiberg (DE)
(72) Inventor: Hohlfeld, Olaf, 59581 Warstein (DE); Britwin, Aleksei, 59602 Rüthen (DE); Bönig, Guido, 59581 Warstein (DE)
(74) Representative: Westphal, Mussgnug & Partner Patentanwälte mbB

(57) **Abstract**

A method includes disposing at least two chip assemblies, each comprising a semiconductor chip (10) and an electrically conductive contact surface, on a common carrier (2), and pressing a contacting arrangement comprising a plurality of electrically conductive contacting elements (301) against each of the contact surfaces so that each of the contact surfaces makes an electrical contact with at least one of the contacting elements (301) and that at least one of the contacting elements (301) is plastically deformed and thereby shortened.

## Description

In applications like press-pack assemblies, two or more semiconductor chips are commonly electrically contacted by a robust, electrically conductive contacting arrangement. In order to make an electrical pressure contact with each of the semiconductor chips, the contacting arrangement is pressed against the semiconductor chip. Because of unavoidable manufacturing tolerances and/or in order to save production costs and/or because of the intentional use of semiconductor chips having different thicknesses, the electrical contact resistance between the contacting arrangement and one or more of the semiconductor chips may be undesirably high. Therefore, there is a need for an improved method of electrically contacting a number of semiconductor chips safely and homogeneously.

According to one aspect, a method includes disposing at least two chip assemblies, each comprising a semiconductor chip and an electrically conductive contact surface, on a common carrier, and pressing a contacting arrangement comprising a plurality of electrically conductive contacting elements against each of the contact surfaces so that each of the contact surfaces makes an electrical contact with at least one of the contacting elements and that at least one of the contacting elements is plastically deformed and thereby shortened.

The invention may be better understood with reference to the following drawings and the description. The components in the figures are not necessarily to scale, emphasis instead being placed upon illustrating the principles of the invention. Moreover, in the figures, like reference numerals designate corresponding parts throughout the different views.
Figure 1A is a cross-sectional side view of an exemplary press-pack module during assembly.
Figure 1B illustrates the elements of the assembly shown in Figure 1A in a state in which a contacting arrangement makes its first electrical contact with a chip assembly.
Figure 1C illustrates the elements of the assembly shown in Figures 1A and 1B in a state in which contacting elements of the contacting arrangement have been plastically deformed and thereby shortened.
Figures 2A to 2D illustrate how different contacting elements of a contacting arrangement subsequently make contact with contact surfaces of the chip assemblies.
Figure 3 illustrates the assembly shown in Figure 1C after detaching the contacting arrangement with the plastically deformed and shortened contacting elements from the chip assemblies.
Figure 4 is a cross-sectional side view of a further example of a press-pack module.
Figure 5 is a cross-sectional side view of an exemplary press-pack module in which each of the chip assemblies has an electrically conductive interface plate loosely disposed between that chip assembly and the contacting arrangement.
Figure 6 is a cross-sectional side view of an exemplary press-pack module during assembly according to Figure 1C, with the difference that each of the contacting elements has, prior to being plastically deformed and thereby shortened for the first time by pressing the contacting arrangement against the chip assemblies, a cross-section that equals a cross-section of a frustum of a pyramid or a cone.
Figure 7 is a cross-sectional side view of an exemplary press-pack module during assembly according to Figure 1C with the difference that each of the contacting elements has, prior to being plastically deformed and thereby shortened for the first time by pressing the contacting arrangement against the chip assemblies, a rounded end at which, when the contacting arrangement is pressed against the carrier, the contacting element makes contact with a contact surface of one of the chip assemblies.
Figure 8 is a cross-sectional side view of an exemplary press-pack module during assembly according to Figure 1C, with the difference that contacting elements designated to contact the same chip assembly are disposed distant from one another.
Figure 9 is a cross-sectional side view of an exemplary press-pack module during assembly according to Figure 7, with the difference that contacting elements designated to contact the same chip assembly are disposed distant from one another.
Figure 10 is a top view of a number of chip assemblies commonly disposed on the same carrier.
Figure 11 illustrates a section of a contacting arrangement to be pressed against chip assemblies with a view to the contacting elements according to a first example.
Figure 12 illustrates a section of a contacting arrangement to be pressed against chip assemblies with a view to the contacting elements according to a second example.
Figure 13 illustrates a section of a contacting arrangement to be pressed against chip assemblies with a view to the contacting elements according to a third example.
Figure 14 illustrates a section of a contacting arrangement to be pressed against chip assemblies with a view to the contacting elements according to a fourth example.
Figure 15 illustrates a section of a contacting arrangement to be pressed against chip assemblies with a view to the contacting elements according to a fifth example.
Figure 16 illustrates a section of a contacting arrangement to be pressed against chip assemblies with a view to the contacting elements according to a sixth example.
Figures 17A and 17B illustrate different steps of the production of a contacting arrangement.
Figure 18A is an enlarged sectional side view of a press-pack module illustrating projected areas of interface surfaces formed between a contact surface of a chip assembly and the contacting elements contacting this contact surface.
Figure 18B is a cross-sectional top view of the contact surface of the chip assembly shown in Figure 18A illustrating the projected area of the first chip metallization of the semiconductor chip of this chip assembly and the projected areas of the interface surfaces.
Figure 19A is a cross-sectional side view of parts of an exemplary press-pack module during assembly in which the contacting arrangement includes several independent parts.
Figure 19B illustrates the parts shown in Figure 19A after assembly in a state in which contacting elements of the contacting arrangement have been plastically deformed.
Figure 20 is an enlarged sectional side view illustrating an interface area between coated contacting elements of a contacting arrangement and a contact surface of a coated chip assembly.
Figure 21 is an enlarged sectional side view illustrating an interface area between a coated pedestal of a contacting arrangement and a coated pressure piece of the contacting arrangement.

In the following detailed description, reference is made to the accompanying drawings. The drawings show specific examples in which the invention may be practiced. It is to be understood that the features of the various examples described herein may be combined with each other, unless specifically noted otherwise. Further, in the description some elements are designated with "first", "second", etc. Such designation is not to be understood as enumeration. Instead, it serves to distinguish different elements or different types of elements. Therefore, stating that there is, e.g., a "second element" does not necessarily mean that there must also be a "first element".

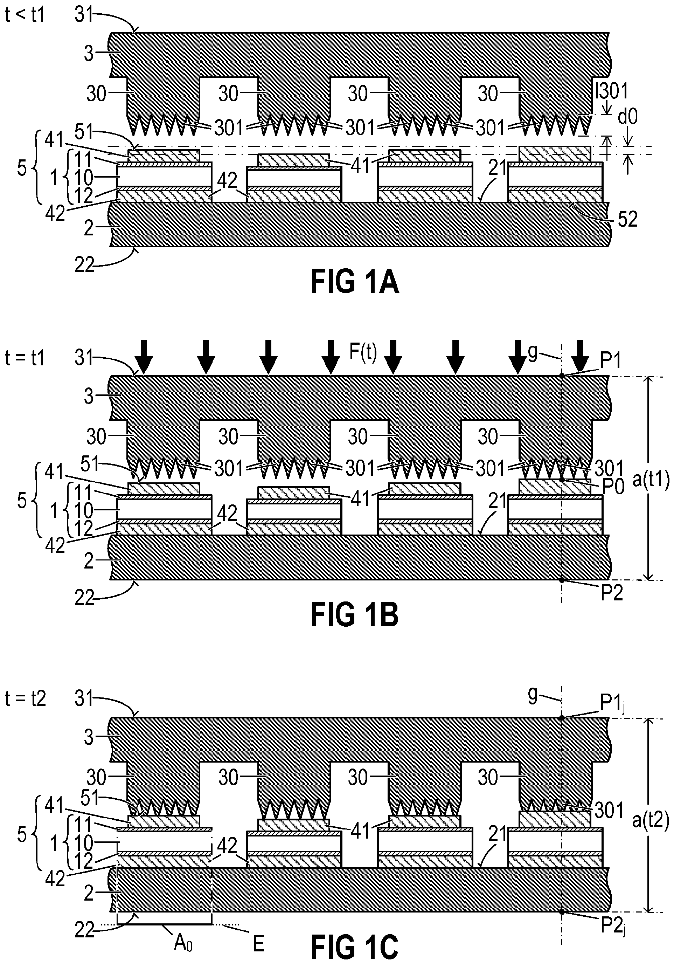

In Figures 1A to 1C different steps during assembly of a pressure-pack module are illustrated. The module has a number of chip assemblies 5. Each chip assembly 5 has a semiconductor chip 1 and a contact surface 51. The contact surfaces 51 are exposed so that they can be electrically contacted. Optionally, the contact surfaces 51 may be plane.

Each semiconductor chip 1 has a semiconductor body 10, and a first chip metallization 11 and a second chip metallization 12 attached to the semiconductor body 10. The semiconductor body 10 is disposed between the first chip metallization 11 and the second chip metallization 12. The semiconductor body 10 may include a semiconductor material having a monocrystalline or substantially monocrystalline structure. One or more doped regions doped with electrically active dopants (i.e. dopants causing the respective region to be n-doped or p-doped) may be formed in the semiconductor body 10. The semiconductor material may be, for instance, silicon, silicon carbide, gallium arsenide, gallium nitride, aluminum gallium nitride, or any other semiconductor material.

The first chip metallization 11 and the second chip metallization 12 may result from one or more deposition processes in which the material of the respective first and/or second chip metallization 11, 12 is deposited on the semiconductor body 10. During the one or more deposition processes, the respective semiconductor body 10 may be part of a wafer. After depositing the first and/or second chip metallization 11, 12 on the respective semiconductor body 10, the respective semiconductor body 10 having the metallizations 11, 12 may be singulated from the wafer in order to obtain the (single) semiconductor chip 1. Each of the first and/or second chip metallizations 11, 12 may consist of one metal layer only, or be formed as multilayer-metallizations with two or more metal sub-layers disposed (stacked) one above the other. In case of a multilayer-metallization, adjoining metal layers of the respective chip metallization 11, 12 have different metal compositions, i.e. different metals or different quantitative compositions. Suitable metals that may be included in a chip metallization 11, 12 are, for instance, aluminum (Al), copper (Cu), titanium (Ti), tantalum (Ta), tungsten (W), or other metals. Optionally, the layer thickness of the first chip metallization 11 may be at least 3 µm, e.g. 3 µm to 20 µm. Also optionally, the layer thickness of the second chip metallization 12 may be at least 3 µm, e.g. 3 µm to 20 µm.

Each of the chip assemblies 5 includes a first intermediate plate 41 which is disposed on the surface of the first chip metallization 11 of the semiconductor chip 1 of the respective chip assembly 5 facing away from the semiconductor body 10 of that semiconductor chip 1. That is, within the same chip assembly 5, the first chip metallization 11 is disposed between the semiconductor body 10 and the first intermediate plate 41.

Optionally, a substance-to-substance-bond may be formed between the first intermediate plate 41 and the respective first chip metallization 11. For instance, there may be an electrically conductive connection layer which continuously extends between the first intermediate plate 41 and the respective first chip metallization 11 and which is substance-to-substance-bonded to both the first intermediate plate 41 and the respective first chip metallization 11. For instance, such an electrically conductive connection layer may be a solder layer (including a diffusion soldered layer), a layer of sintered metal powder (e.g. a sintered silver powder), or an electrically conductive adhesive layer. Alternatively to forming a substance-to-substance-bond between the first intermediate plate 41 and the respective first chip metallization 11, the first intermediate plate 41 may be loosely disposed on the respective first chip metallization 11.

In any case, such a first intermediate plate 41 serves to protect the respective semiconductor chip 1, in particular the semiconductor body 10 thereof, against being mechanically damaged when, as will be described below, the contacting arrangement 3 is pressed against the semiconductor chip 1 in order to form an electrically conductive connection between the contacting arrangement 3 and the first chip metallization 11 of that semiconductor chip 1.

In order to also reduce thermomechanical stress that can arise if the coefficients of linear thermal expansion of the contacting arrangement 3 and the semiconductor body 10 of the semiconductor chip 1 differ significantly, a first intermediate plate 41 may optionally have, at a temperature of 20°C, a coefficient of linear thermal expansion of less than 8 ppm/K. Suitable materials the first intermediate plates 11 may consist of or comprise in order to achieve such a low coefficient of thermal expansion are, for instance, molybdenum, tungsten, or a metal-matrix-composite material (e.g. aluminum silicon carbide).

Further, between each of the chip assemblies 5 and the carrier 2 a second intermediate plate 42 may be disposed on the surface of the second chip metallization 12 of the semiconductor chip 1 of the respective chip assembly 5 facing away from the semiconductor body 10 of that semiconductor chip 1. That is, for each chip assembly 5, the second chip metallization 12 is disposed between the semiconductor body 10 and a second intermediate plate 42.

Instead of providing individual second intermediate plates 42 for each of the chip assemblies 5, at least two (e.g. all) semiconductor chip assemblies 5 may share a common second intermediate plate 42 in that the common second intermediate plate 42 is disposed between the carrier 2 and each of the second chip metallizations 12 of the semiconductor chips 1 of those chip assemblies 5. Optionally, a substance-to-substance-bond may be formed between the shared second intermediate plate 42 and the second chip metallizations 12 of the semiconductor chips 1 of the chip assemblies 5 sharing the second intermediate plate 42.

Individual second intermediate plates 42 or a shared second intermediate plate 42 may consist of or comprise, for instance, the materials mentioned above with reference to the first intermediate plates 41. Thereby, the first and (shared or non-shared) second intermediate plates 42 may consist of or include the same or different materials or material compositions. According to one example, the first intermediate plates 41 and the second intermediate plates 42 or the first intermediate plates 41 and a shared second intermediate plate 42 consist of or comprise molybdenum.

In order to join the shared or the individual second intermediate plates 42 and the semiconductor chips 1, electrically conductive connection layers may be used. Such electrically conductive connection layers continuously extend between the second intermediate plate(s) 42 and the second chip metallizations 12 and are substance-to-substance-bonded to both the second intermediate plate(s) 42 and the respective second chip metallization 12. For instance, such an electrically conductive connection layer may be a solder layer, a layer of sintered metal powder (e.g. a sintered silver powder), diffusion solder layer, or an electrically conductive adhesive layer. Alternatively to forming a substance-to-substance-bond between the second intermediate plate(s) 42 and the respective second chip metallizations 12, the second intermediate plate(s) 42 may be loosely disposed on the second chip metallizations 12.

In any case, the second intermediate plate(s) 42 serve to prevent or at least reduce thermomechanical stress that can arise if the coefficients of linear thermal expansion of the carrier 2 and the semiconductor bodies 10 of the semiconductor chips 1 differ significantly. Individual second intermediate plates 42 or a shared second intermediate plate 42 may each optionally have, at a temperature of 20°C, a coefficient of linear thermal expansion of less than 8 ppm/K. Suitable materials that an individual or shared second intermediate plate 42 may consist of or comprise in order to achieve such a low coefficient of thermal expansion are, for instance, molybdenum, titanium, tungsten, or a metal-matrix-composite material (e.g. aluminum silicon carbide).

A carrier 2 may consist of or comprise an electrically low-resistive material like a metal, e.g. copper or aluminum. Similarly, a contacting arrangement 3 may consist of or comprise an electrically low-resistive material like a metal, e.g. copper or aluminum. According to one example, each of the carrier 2 and the contacting arrangement 3 may consist of or comprise copper.

As shown in Figure 1A, the contacting arrangement 3 comprises a number of electrically conductive contacting elements 301 which may be protrusions of the contacting arrangement 3. For instance, the protrusions may be elongate. According to one example, such protrusions may be formed as pins. The contacting elements 301 serve to make an electrical contact between the contacting arrangement 3 and each of the contact surfaces 51 of the chip assemblies 5. In Figure 1A, dashed lines illustrate that the contact surfaces 51 can, because of, e.g., unavoidable manufacturing tolerances, be situated at different levels. For instance, a difference d0 between different levels may be in a range from 2 µm to 50 µm. As will be explained with reference to Figures 1 B and 1C, the contacting elements 301 serve to compensate for these different levels by being plastically deformed and, thereby, shortened when the contacting arrangement 3 is pressed against the contact surfaces 51. That is, the plastic deformation and the resulting shortening is caused by the applied pressing force. The shortening may take place parallel or substantially parallel to a direction of the pressing force. Each of the contacting elements 301 may have an elongate shape and extend in a longitudinal direction. A direction of the applied pressing force may be parallel or substantially parallel to the longitudinal direction.

When the contacting arrangement 3 is moved towards the contact surfaces 51 with the contacting elements 301 ahead, there will be, at a first point of time t1 illustrated in Figure 1B, a first contact between the contacting arrangement 3 and one of the contact surfaces 51, i.e. between one of the contacting elements 301 and one of the contact surfaces 51. In Figure 1B, the point P0 illustrates that point of all contact surfaces 51 at which the contacting arrangement 3 first makes contact with one of the contact surfaces 51.

At that first point of time t1 of the first contact, (at least) one straight line g can be found which contains the point P0 of the first contact, a first point P1 and a second point P2. The first point P1 is a point at which the straight line g intersects a surface 31 of the contacting arrangement 3, whereby the surface 31 is a surface of the contacting arrangement 3 facing away from the contacting elements 301. The second point P2 is a point at which the straight line g intersects a carrier surface 22 of the carrier 2, whereby the carrier surface 22 is a surface of the carrier 2 facing away from the chip assemblies 5. At the first point of time t1, there is a first distance a(t1) between the first point P1 and the second point P2.

When the contacting arrangement 2 is, subsequently to the first point of time t1, further pressed against the contact surfaces 51 with a (with the time t variable) pressing force F(t), one or at least some of the contacting elements 301 are pressed against opposite contact surfaces 51 and thereby plastically deformed and shortened so that the distance a(t) between the same points P1 and P2 decreases. In Figure 1B, the direction of the pressing is indicated by bold arrows. At a second point of time t2 illustrated in Figure 1C, pressing the contacting arrangement 2 against the contact surfaces 51 is completed, and the distance between the points P1 and P2 has decreased from the first distance a(t1) to a second distance a(t2). According to one example, the difference a(t1)-a(t2) between the first distance a(t1) and the second distance a(t2) may be at least 10 µm, e.g. from 10 µm to 100 µm. This ensures a proper electrical contact between the contacting arrangement 3 and the contact surface 51.

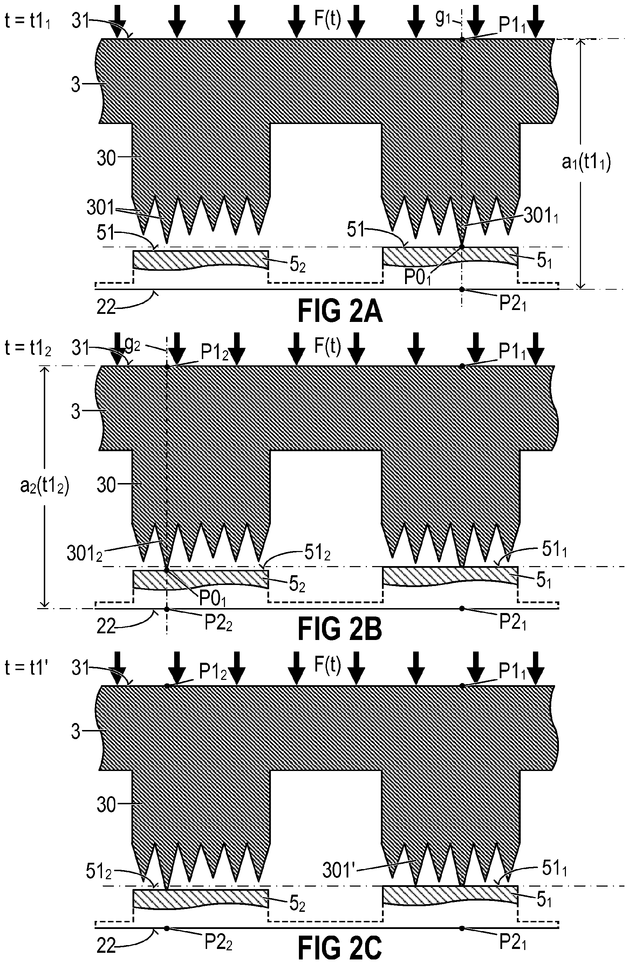

A similar condition may apply with respect to the first contacts between at least two or even each of the contact surfaces 51 and, in each case, one of the contacting elements 301. This will be explained with reference to Figures 2A to 2D. Figures 2A to 2D exemplarily show two chip assemblies 5. In order to distinguish between different chip assemblies 5, indices "1" and "2" are used. Identical indices shall express a relationship between the respective element and the chip assembly 5₁, 5₂ having the same index "1" or "2", respectively. For instance, a (first) contact surface 51₁ is a contact surface 51 of a (first) chip assembly 5₁, and a (second) contact surface 51₂ is a contact surface 51 of a (second) chip assembly 5₂. In order to express that the number N of chip assemblies 5 with N > 1 is arbitrary, in the description of Figures 2A to 2D an index "j" with j = 1...N is used.

For the sake of clearness, the chip assemblies 5 (i.e. 5₁, 5₂) and the carrier 2 are illustrated only schematically. The design of the chip assemblies 5 (i.e. 5₁, 5₂) attached to the carrier 2 may be the same as described with reference to Figures 1A to 1C.

When the contacting arrangement 3 is moved towards the contact surfaces 51 with the contacting elements 301 ahead, for each of the chip assemblies 5ⱼ, there will, at a point of time t1ⱼ of the first contact between the contact surface 51ⱼ of that chip assembly 5ⱼ and one of the contacting elements 301, be a point P0ⱼ which is that point of the respective contact surface 51ⱼ at which the respective contact surface 51ⱼ first makes contact with the contacting arrangement 3, i.e. with one of the entirety of the contacting elements 301. For instance, Figure 2A illustrates the first contact between the contact surface 51₁ of a first chip assembly 5₁ and a contacting element 301₁ at a point P0₁ of the contact surface 51₁ and at a point of time t1₁, and Figure 2B illustrates the first contact between the contact surface 51₂ of a second chip assembly 5₂ and a contacting element 301₂ at a point P0₁ of the contact surface 51₂ and a point of time t1₂. The respective contacting element 301 that first makes contact with a contact surface 51ⱼ is designated with 301ⱼ. Figure 2C illustrates that a contact surface 51 (here: 51₁) may, at or after the respective point of time t1 (here: t1₁) of the first contact between this contact surface 51 (here: 51₁) and one of the contacting elements 301 (here: 301₁), make contact with one or more contacting elements 301 (here: 301').

Generally, at a point of time t1ⱼ, a first contact between the contact surface 51ⱼ of a chip assembly 5ⱼ and the contacting arrangement 3 (i.e. between the contact surface 51ⱼ of that chip assembly 5ⱼ and one of the contacting elements 301) takes place at a point P0ⱼ of the contact surface 51ⱼ. At that point of time t1ⱼ, (at least) one straight line gⱼ can be found which contains the point P0ⱼ of the first contact, a first point P1ⱼ and a second point P2ⱼ. The first point P1ⱼ is a point at which the straight line gⱼ intersects a surface 31 of the contacting arrangement 3, whereby the surface 31 is a surface of the contacting arrangement 3 facing away from the contacting elements 301, and the second point P2 is a point at which the straight line gⱼ intersects a carrier surface 22 of the carrier 2, whereby the carrier surface 22 is a surface of the carrier 2 facing away from the chip assemblies 5. At the point of time t1ⱼ, there is a first distance aⱼ(t1ⱼ) between the respective first point P1ⱼ and the respective second point P2ⱼ. For instance, Figure 2A illustrates the first distance a₁(t1₁) between the first point P1₁ and the respective second point P2₁ at the point of time t1₁, and Figure 2B illustrates the first distance a₂(t1₂) between the first point P1₂ and the respective second point P2₂ at the point of time t1₂.

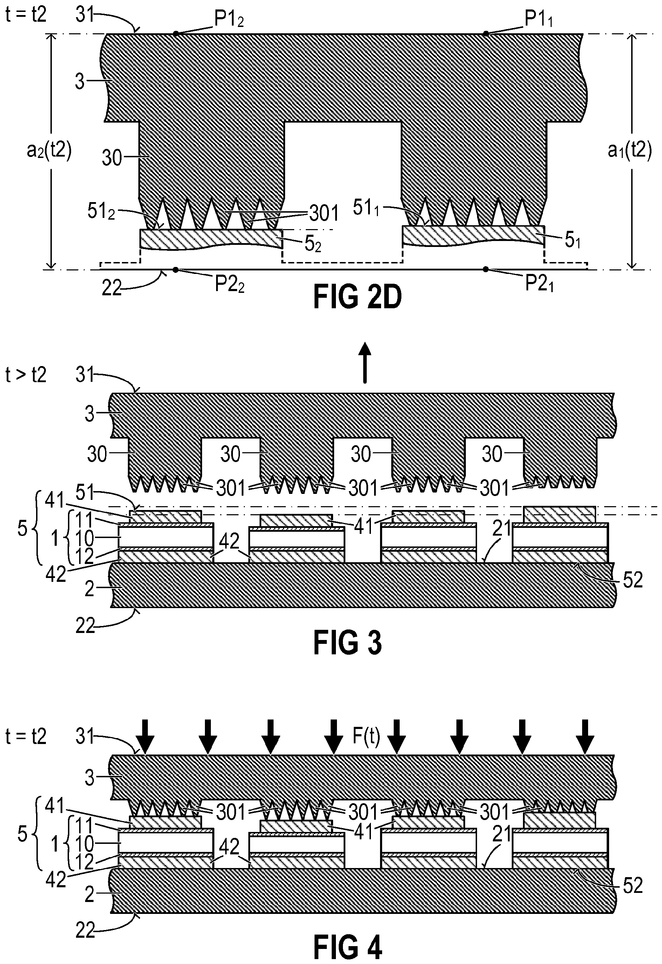

At a second point of time t2 illustrated in Figure 2D, pressing the contacting arrangement 2 against the contact surfaces 51 is completed, and the distance between each pair of points P1ⱼ and P2ⱼ has decreased from the first distance aⱼ(t1ⱼ) to a second distance aⱼ(t2ⱼ). For at least two or even for all of the N chip assemblies 5j, the difference between the respective first distance aⱼ(t1ⱼ) and the respective second distance aⱼ(t2ⱼ) may be at least 50 µm. At the second point of time t2, each contacting element 301ⱼ that has made the first contact between the contacting arrangement 3 and a contact surface 51ⱼ of a chip assembly 5ⱼ, is, compared with a point of time prior to the point of time at which the contacting arrangement 3 first makes contact with the entirety of all contact surfaces 51ⱼ (i.e. the point of time at which the contacting arrangement 3 firstly contacts a contact surface 51j), plastically deformed and thereby shortened. Figure 2D exemplarily illustrates the second distances a₁(t2) between the respective first point P1₁ and the respective second point P2₁ and a₂(t2) between the respective first point P1₂ and the respective second point P2₂.

According to one example, at the second point of time t2, all contacts between the contacting elements 301 and the contact surfaces 51 may be mere pressure contacts so that the connection between the contacting arrangement 3 and the contact surfaces 51 is detachable. Figure 3 illustrates when the contacting arrangement 3 is, subsequent to the second point of time t2, removed from all contact surfaces 51 so that the electrical contacts between the contacting elements 301 and the contact surfaces 51 are interrupted (i.e. so that the electrical contact between the contacting arrangement 3 and all contact surfaces 51 is interrupted). It is to be noted that the contacting elements 301 remain deformed because of the mentioned plastic deformation. This will be apparent when comparing the undeformed contacting elements 301 illustrated in Figure 1A with the plastically deformed and shortened contacting elements 301 illustrated in Figure 3.

As further illustrated in Figures 1A to 1C, 2A to 2D and 3, the contacting arrangement 3 may, for each of the chip assemblies 5ⱼ, optionally have a pedestal 30ⱼ so that the contacting elements 301 for making contact with the contact surface 51ⱼ of the corresponding chip assembly 5ⱼ are formed at a surface of the contacting arrangement 3 opposite the surface 31. Alternatively, the pedestals 30 (i.e. the pedestals 30ⱼ) may be omitted, which is illustrated in Figure 4 which. Apart from the omitted pedestals 30ⱼ, Figure 4 corresponds with Figures 1C and 2D.

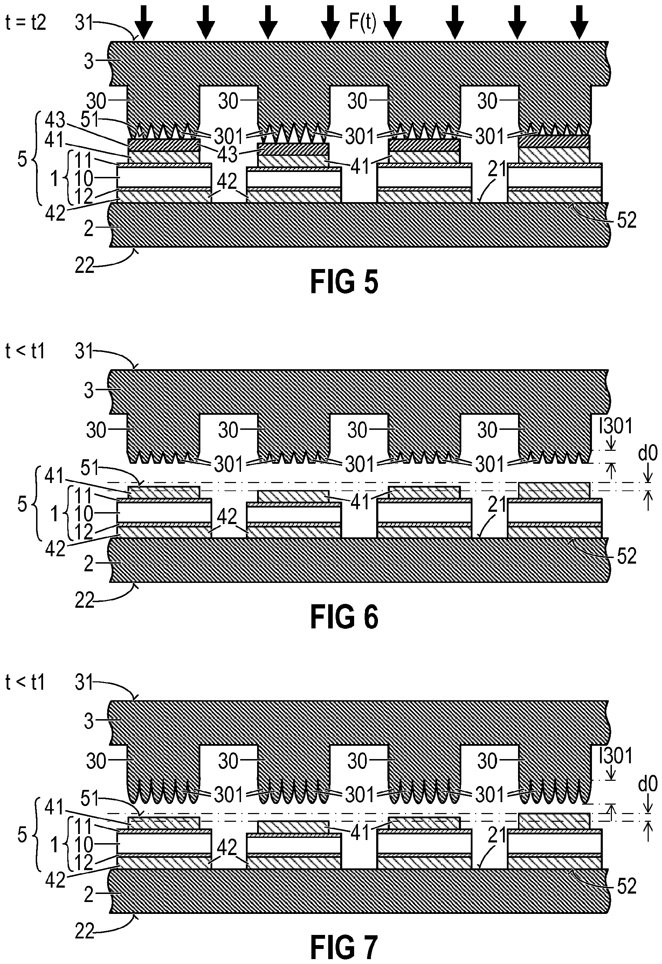

As further illustrated in the above drawings, a contact surface 51, 51ⱼ of a chip assembly 5, 5ⱼ may be a surface of the first intermediate plate 41 of that chip assembly 5, 5ⱼ. However, this is only an example. According to a further example illustrated in Figure 5, each of the chip assemblies 5 may include a corresponding third intermediate plate 43 which is, at the end of the pressing of the contacting arrangement 3 against the chip assemblies 5, loosely disposed between the first intermediate plate 41 of that chip assembly 5 and the contacting arrangement 3. Thereby, the contact surface 51 a chip assembly 5 may be a surface of the third intermediate plate 43 of that chip assembly 5. Optionally, for each of the chip assemblies 5, the third intermediate plate 43 of that chip assembly 5 may have a coefficient of linear thermal expansion that is greater than a coefficient of linear thermal expansion of the third intermediate plate 43 of that chip assembly 5. In such a design, the coefficient of linear thermal expansion of the first intermediate plate 41 is greater than the coefficient of linear thermal expansion of the semiconductor body 10 of the semiconductor chip 1 of the same chip assembly 5, but less than the coefficient of linear thermal expansion of the third intermediate plate 43 of that chip assembly 5. For instance, the third intermediate plates 43 may consist of or comprises at least one of the following materials: copper; aluminum. However, other electrically conductive materials, e.g. metals, may also be used.

According to a further example (not shown), the first intermediate plates 41 and the third intermediate plates 43 may be omitted so that the contact surface 51 of a chip assembly 5 is a surface of the first chip metallization 11 of the semiconductor chip 1 of the respective chip assembly 5.

Irrespective of the elements (e.g. the first chip metallization 11 or the first intermediate plate 41 or the third intermediate plate 43) forming the contact surfaces 51, all contacts between the surfaces 51 and the contacting elements 301 may be detachable so that the contacting arrangement 3 may be removed from the contact surfaces 51. That is, at the end of the pressing of the contacting arrangement 3 against the chip assemblies 5, each of the contacting elements 301 which make an electrical contact with one of the contact surfaces 51 forms a detachable electrical connection with that contact surface 51. According to a further option, each contacting element 301 may, prior to the first contact between the contacting arrangement 3 and the entirety of the contact surfaces 51 (i.e. prior to the point of time t1), taper off. That is, for all contacting elements 301 there may be one direction perpendicularly to which the cross-sectional area of each contacting element 301 decreases, or even strictly monotonically decreases. Optionally, the one direction may be identical with the direction of the pressing force F(t), which in Figures 1B, 2A to 2C, 4 and 5 is indicated by a bold arrow. The effect of the tapering is that a pressing force F(t) which is low enough to not cause a physical damage of the semiconductor chip 1 of the respective chip assembly 5 is still high enough to cause a plastic deformation and shortening of the contacting element 301 when the contacting element 301 is pressed against the contact surface 51. For instance, the pressing force F(t) may be such that a contact pressure between the first intermediate plate 41 and the semiconductor chip 1 does not exceed 10 N/mm². For example, the maximum pressing force F(t) may be such that a contact pressure between the first intermediate plate 41 and the semiconductor chip 1 is in a range from 3 N/mm² to 10 N/mm².

Various examples of contacting elements 301 which have, at a point of time t prior to the point of time t1 of the first contact between the contacting arrangement 3 and the entirety of the contact surfaces 51, monotonically or even strictly monotonically decreasing cross-sections, are illustrated in Figures 1A, 6, 7, 8 and 9. According to Figure 1A, each contacting element 301 may have a vertical cross-section identical to a cross-section of a pyramid or of a cone. According to Figure 6, each contacting element 301 may have a vertical cross-section identical to a cross-section of a frustum of a pyramid or of a cone. According to Figure 7, each contacting element 301 may have a rounded end at which, when the contacting arrangement 3 is pressed against the carrier 2, the contacting element 301 makes contact with a contact surface 51 of one of the chip assemblies 5.

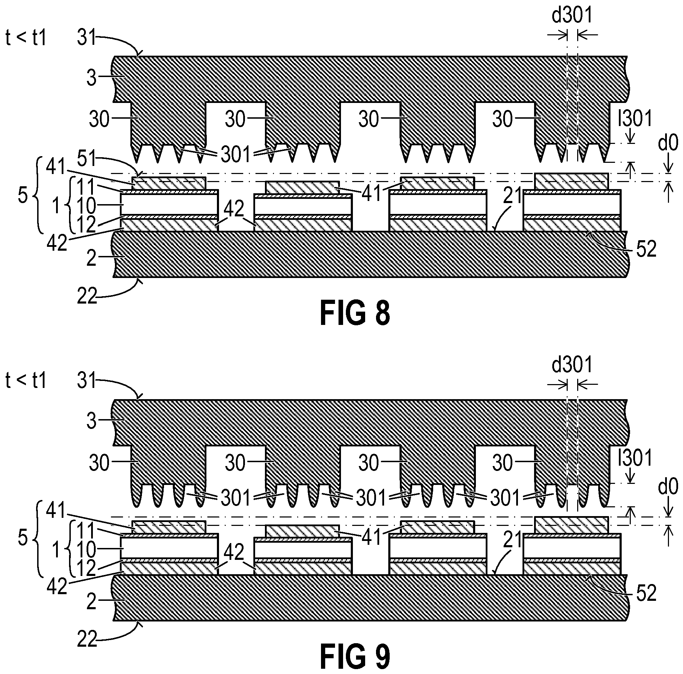

According to the examples illustrated above, adjacent contacting elements 301 for contacting the same contact surface 51 may adjoin. Alternatively, as illustrated in Figures 8 and 9, adjacent contacting elements 301 for contacting the same contact surface 51 may be disposed distant from one another. For instance, a distance d301 between adjacent contacting elements 301 for contacting the same contact surface 51 may be 10 µm to 1 mm. For the rest, Figure 8 corresponds with Figure 1A, and Figure 9 corresponds with Figure 7. Generally, however, adjacent contacting elements 301 of any shape may be disposed distant from one another.

As also illustrated in the examples described above, each contacting element 301 has, in the direction of the pressing force F(t), a length l301. The length l301 may be, for instance, at least 30 µm, e.g. 30 µm to 2 mm, or even at least 100 µm, e.g. 100 µm to 2 mm.

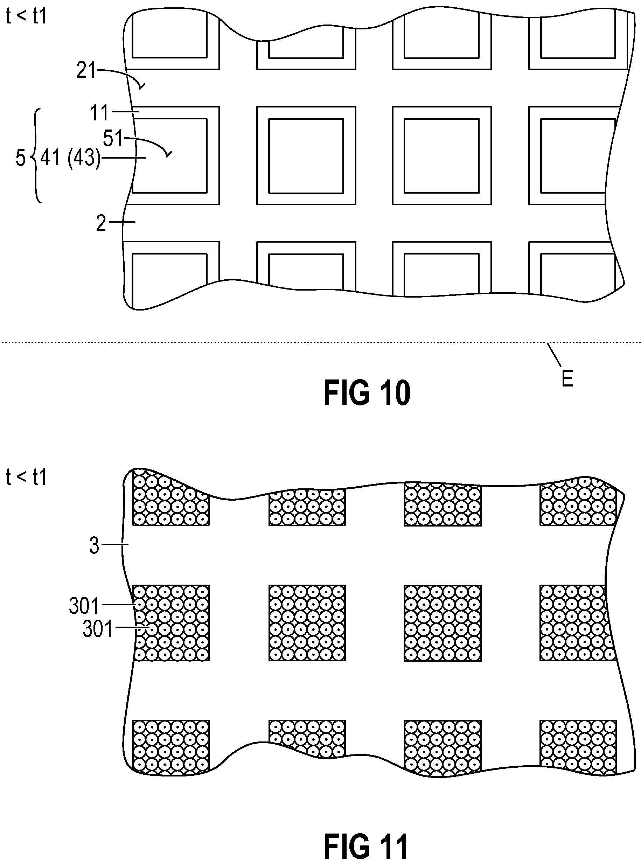

Figure 10 is a top view of a section of an assembly group that has a number of chip assemblies 5 commonly disposed on the same carrier 2, with a view to the contact surfaces 51. Figures 11 to 16 illustrate corresponding sections of contacting arrangements 3 that may be used for electrically contacting the contact surfaces 51 of the assembly group of Figure 10, with a view to the (still undeformed) contacting elements 301. Prior to electrically contacting the contact surfaces 51 of the assembly group of Figure 10 at a first point of time t1, the contacting arrangements 3 of Figures 11 to 16 need to be turned upside down so that the contacting elements 301 face towards the contact surfaces 51.

In the example of Figure 11, each of the contacting elements 301 of the contacting arrangement 3 has a conical shape or a rounded tip. Possible corresponding cross-sections are illustrated in Figures 1A, 2A and 7.

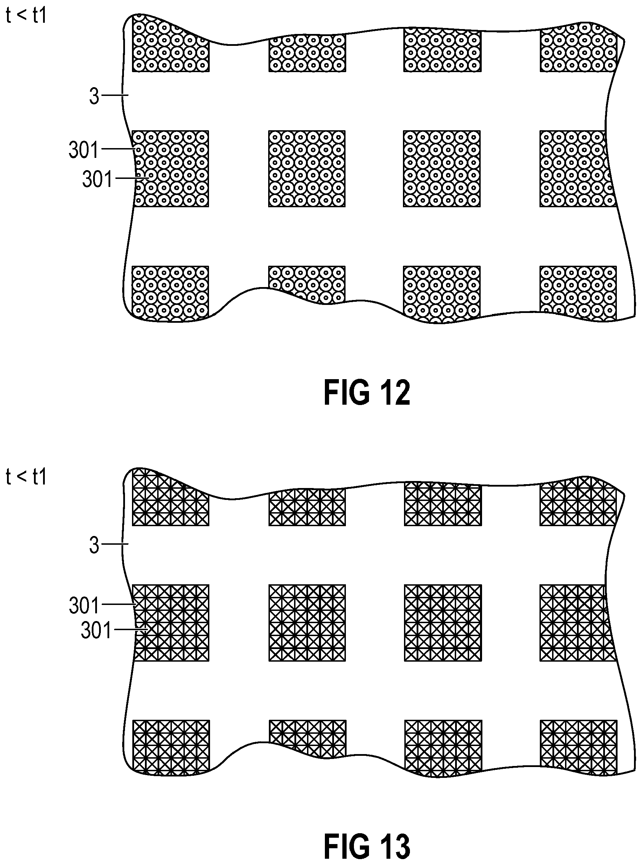

In the example of Figure 12, each of the contacting elements 301 of the contacting arrangement 3 has the shape of a truncated cone. A possible corresponding cross-section is illustrated in Figure 6.

In the example of Figure 13, each of the contacting elements 301 of the contacting arrangement 3 has the shape of a pyramid. Possible corresponding cross-sections are illustrated in Figures 1A and 2A.

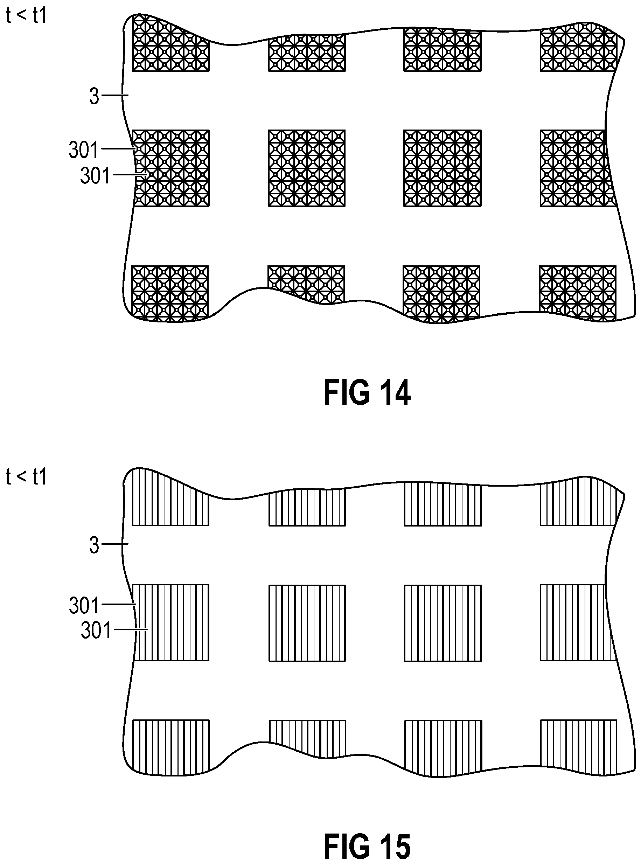

In the example of Figure 14, each of the contacting elements 301 of the contacting arrangement 3 has the shape of a truncated pyramid. A possible corresponding cross-section is illustrated in Figure 6.

In the example of Figure 15, each of the contacting elements 301 of the contacting arrangement 3 extends in a longitudinal direction and has, perpendicularly to the longitudinal direction, identical cross-sections. Possible corresponding cross-sections are illustrated in Figures 1A and 2A.

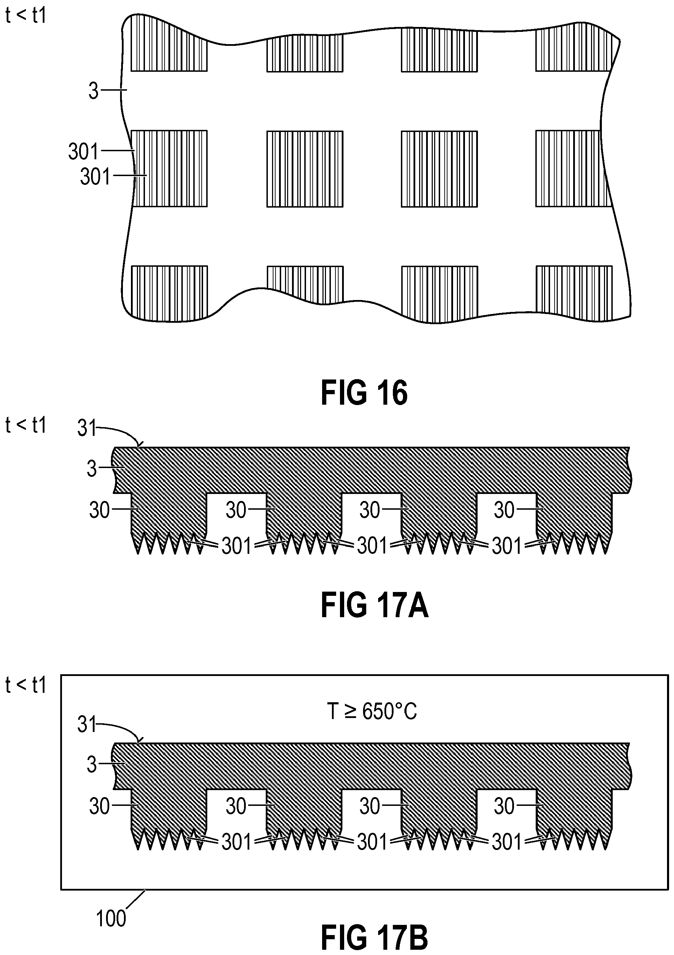

In the example of Figure 16, each of the contacting elements 301 of the contacting arrangement 3 extends in a longitudinal direction and has, perpendicularly to the longitudinal direction, identical cross-sections. A possible corresponding cross-section is illustrated in Figure 6.

Figures 17A and 17B illustrate different steps of the production of a contacting arrangement 3. In order to produce a contacting arrangement 3 having contacting elements 301, a metal plate (e.g. a plane metal plate) may be treated, e.g. by stamping, cold pressing, cutting (e.g. milling), by "micro deformation technology" (MDT) of Wolverine Tube Inc. Decatur, AL 35601, USA, by etching, by sandblasting, or by any other formative method. Figure 17A illustrates such a contacting arrangement 3.

Subsequently, in order to increase the ductility and to reduce the hardness at least of the contacting elements 301 (or even of the contacting arrangement 3 as a whole), at least the contacting elements 301 (or even of the contacting arrangement 3 as a whole) may be soft-annealed. The soft-annealing of the contacting arrangement 3 as a whole may take place in an annealing furnace 100 in which the contacting arrangement 3 is placed and heated to temperatures of at least a minimum annealing temperature. Alternatively to soft-annealing the contacting arrangement 3 as a whole, only a part of the contacting arrangement 3 may be heated to temperatures of at least the minimum annealing temperature. This part of the contacting arrangement 3 includes at least the contacting elements 301 so that at least the contacting elements 301 are soft annealed. For example, the soft-annealing of only this part of the contacting arrangement 3 may take place by laser treatment or any other suitable technique. Optionally, the minimum annealing temperature may be 650°C.

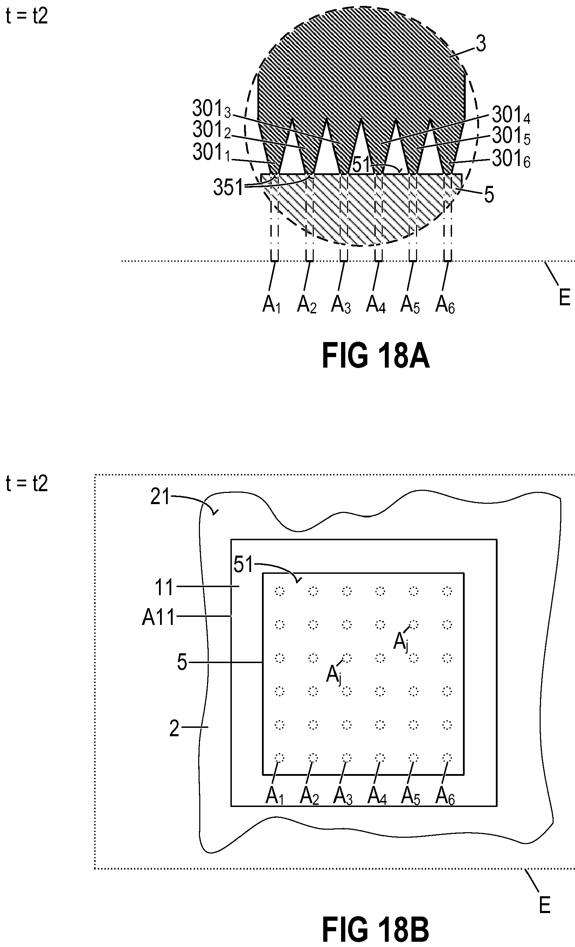

Figure 18A is an enlarged sectional side view of a press-pack module, in which contacting elements 301₁, 301₂, 301₃, 301₄, 301₅, 301₆ of a contacting arrangement 3 are pressed against the same contact surface 51 of a chip assembly 5. Figure 18B is a cross-sectional top view of the contact surface 51 of the chip assembly 5 of Figure 18A. The cross-section is taken between the contacting arrangement 3 and the contact surface 51. For the first chip electrode 11 of the chip assembly 5 (i.e. the chip electrode 11 that is electrically connected to the contact surface 51), there is a projection plane E in which the area of an orthogonal projection of the first chip electrode 11 is maximum and has a maximum projection area A11. The interface surfaces 351 between all contacting elements 301ⱼ contacting the same contact surface 51 and the contact surface 51 can also be projected onto the projection plane E where they have projection areas Aⱼ. Some of the projection areas Aⱼ are given by the projection areas A₁, A₂, A₃, A₄, A₅, A₆ caused by the contacting elements 301₁, 301₂, 301₃, 301₄, 301₅, 301₆ shown in Figure 18A. Adding the projection areas Aⱼ of the interface surfaces 351 formed between all contacting elements 301ⱼ contacting the same contact face 51 gives a total projected contact area Aₜₒₜ. The more firmly the contacting arrangement 3 is pressed against the contact face 51, the greater is the total projected contact area Aₜₒₜ and the lower is the electrical contact resistance between the contact surface 51 and the contacting arrangement 3. In order to achieve a low electrical contact resistance, the ratio Aₜₒₜ ÷ A11 between the total projected contact area Aₜₒₜ and the maximum projection area A11 may, for instance, be at least 0.1. Optionally, the same lower limit of 0.1 may apply for the corresponding ratios of all chip assemblies 5 of the press-pack module. Generally, however, ratios of less than 0.1 may also be used.

With the present invention, various press-packs assemblies may be realized. In such a press-pack assembly, at the end of the pressing of the contacting arrangement 3 against the chip assemblies 5, the first chip metallizations 11 of the semiconductor chips 1 of all chip assemblies 5 may be electrically interconnected by the contacting arrangement 3, and the second chip metallizations 12 of the semiconductor chips 1 of all chip assemblies 5 may be electrically interconnected by the carrier 2. Optionally, the carrier 2 may also have carrier contacting elements according to the contacting elements 301 so that each of the intermediate plates 42 is electrically contacted by at least two carrier contacting elements which are plastically deformed and thereby shortened during the process of contacting the respective intermediate plate 42.

As illustrated in the previous examples, the contacting arrangement 3 may be formed monolithically. If the contacting arrangement 3 also includes pedestals 30, the contacting elements 301 may also be protrusions of the pedestals 30.

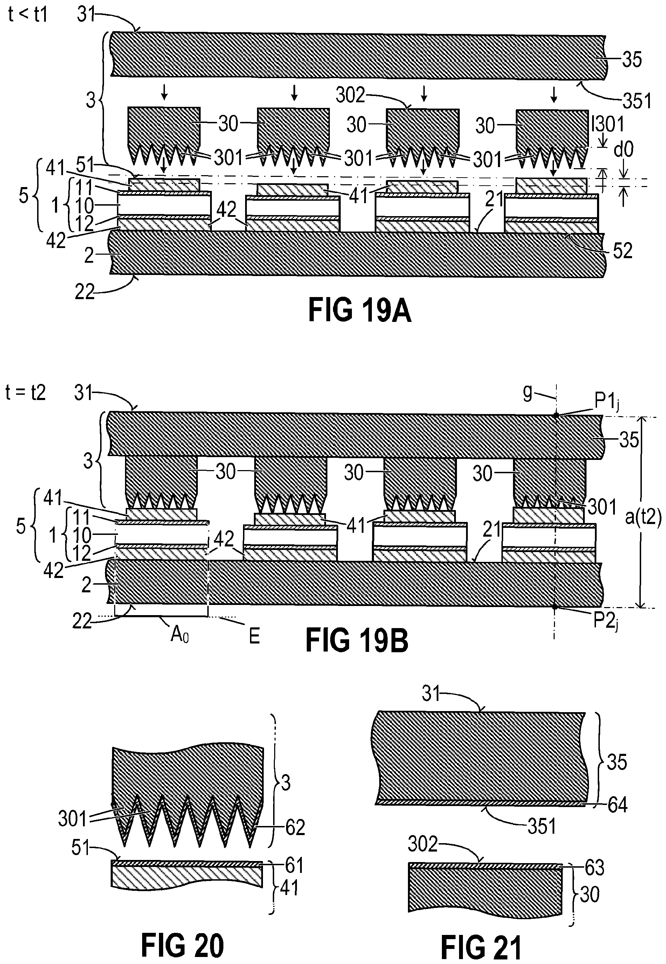

However, instead of a monolithically formed contacting arrangement 3 that includes the contacting elements 301 and, optionally, the pedestals 30, a contacting arrangement 3 may, as illustrated in Figure 19A, include at least two pedestals 30 each including at least one or at least two contacting elements 301 formed as protrusions of the respective pedestal 30, and a pressure piece 35 which serves to electrically contact the at least two pedestals 30. As shown, the surface 31 of the contacting arrangement 3 may be a surface of the pressure piece 35.

Each of the at least two pedestals 30 includes a surface 302 for physically and electrically contacting a further surface 351 of the pressure piece 35. The surface 31 and the further surface 351 may be opposite surfaces of the pressure piece 35.

During assembly of the parts shown in Figure 19A, each of the at least two pedestals 30 is, with its contacting elements 301 facing towards the contact surface 51 to be contacted by that contacting elements 301 and with its surface 302 facing towards the pressure piece 35, disposed between the pressure piece 35 and the contact surface 51 to be contacted. Subsequently, the pressure piece 35 is pressed against the pedestals 30 so that the contacting elements 301 of the pedestals 30 are pressed against the corresponding contact surfaces 51 and deformed and shortened in the same manner described above with reference to Figures 1A to 1C. In other words, the contacting arrangement 3 is pressed against the contact surfaces 51. Due to the pressing, the surfaces 302 of the pedestals 30 make pressure contacts with the further surface 351 of the contact piece 35 and the contacting elements 301 make pressure contacts with the respective contact surfaces 51 so that the contact surfaces 51 are electrically interconnected by the contacting arrangement 3. By virtue of the pressing, the contacting elements 301 are plastically deformed and thereby shortened. Figure 19B illustrates the assembled state of the press-pack module of Figure 19A.

Apart from the fact that the pedestals 30 (including the contacting elements 301) and the pressure piece 35 are separate parts which are moveable relative to one another (i.e. there are no substance-to-substance bonds between the pressure piece 35 and the pedestals 30), Figure 19A corresponds to Figure 1A, and Figure 19B corresponds to Figure 1C, and all features and methods explained with reference to Figures 1A to 1C including the modifications thereof described with reference to Figures 2A to 18B apply identically or analogously for assemblies in which at least two pedestals 30 (including the contacting elements 301) and a pressure piece 35 are separate parts which are moveable relative to one another. It is to be noted that the first distances aⱼ(t1ⱼ) between the respective first point P1j and the respective second point P2ⱼ at the point of time t1ⱼ are to be measured in a state in which the surface 302 of the pedestal 30 which makes contact with the respective contact surface 51ⱼ at the corresponding point P0ⱼ abuts the further surface 351 of the pressure piece 35.

During operation of an assembly described above with reference to Figures 1 A to 19B, different coefficients of thermal expansion of different parts of the assembly may cause thermomechanical stress. In order prevent or at least reduce such thermomechanical stress, certain parts of the assembly may have coatings in order to facilitate a relative movability between abutting parts.

According to a first example illustrated in Figure 20, one, some or each of the contact surfaces 51 may be formed by a metallic first coating 61 of the chip assembly 5, and/or one, some or each the contacting elements 301 may include a metallic second coating 62. For instance, one of the first coating 61 and the second coating 62 may consist of or include nickel (Ni), and the other of the first coating 61 and the second coating 62 may consist of or include silver (Ag), or may consist of or include ruthenium (Ru). A first coating 61 and/or a second coating 62 may optionally be used in connection with all examples described with reference to Figures 1A to 19B.

According to a second example illustrated in Figure 21, which applies for assemblies in which the contacting arrangement 3 includes, as explained with reference to Figures 19A and 19B, at least two pedestals 30 and a pressure piece 35 as separate parts, one, some or each of the pedestal surfaces 302 may be formed by a metallic third coating 63, and/or the further surface 351 of the pressure piece 35 may be formed by a metallic fourth coating 64. For instance, one of the third coating 63 and the fourth coating 64 may consist of or include nickel (Ni), and the other of the third coating 63 and the fourth coating 64 may consist of or include silver (Ag), or may consist of or include ruthenium (Ru). A third coating 63 and/or a fourth coating 64 may optionally be used in combination with a first coating 61 and/or a second coating 62.

Instead of a first coating 61 explained with reference to Figure 20, a first intermediate plate 41 may be made of aluminum so that the contact surface 51 of that intermediate plate 41 is an aluminum surface. The aluminum may have a high purity, for instance at least 99.99%, and therefore be soft so that the contacting elements 301 can penetrate the intermediate plate 41 to a certain degree and establish a reliable electrical contact with the intermediate plate 41.

## Claims

1. A method comprising:
disposing at least two chip assemblies, each comprising a semiconductor chip and an electrically conductive contact surface, on a common carrier;
pressing a contacting arrangement comprising a plurality of electrically conductive contacting elements against each of the contact surfaces so that each of the contact surfaces makes an electrical contact with at least one of the contacting elements and that at least one of the contacting elements is plastically deformed and thereby shortened.

2. The method of claim 1, wherein for each of the contact surfaces, at least one contacting element that makes an electrical contact with this contact surface is plastically deformed and thereby shortened by virtue of the pressing.

3. The method of claim 1 or 2, wherein all contacting elements are, prior to pressing the contacting arrangement against the contact surfaces, electrically interconnected.

4. The method as claimed in one of the preceding claims, wherein
the carrier comprises a carrier surface facing away from the chip assemblies;
the contacting arrangement comprises a surface facing away from the contacting elements;
one of the contacting elements makes, at a first point of time, an electrical contact with one of the contact surfaces at a contact point of that contact surface;
at the first point of time, the contact point, a first point of the surface of the contacting arrangement and a second point of the carrier surface are located on a straight line;
at the first point of time, there is a first distance between the first point and the second point;
at a second point of time subsequent to the first point of time, there is a second distance between the first point and the second point with the first distance being at least 10 µm greater than the second distance.

5. The method as claimed in one of the preceding claims, wherein
the semiconductor chip of each of the chip assemblies comprises a first chip metallization, a second chip metallization, and a semiconductor body disposed between the first chip metallization and the second chip metallization;
each of the chip assemblies comprises a first intermediate plate attached and electrically connected to the first chip metallization of the semiconductor chip of the respective chip assembly; and
each of the contact surfaces is a surface of one of the first intermediate plates.

6. The method as claimed in claim 5, wherein
each of the chip assemblies comprises a corresponding third intermediate plate that is, at the end of the pressing of the contacting arrangement against the chip assemblies, loosely disposed between the first intermediate plate of that chip assembly and the contacting arrangement;
for each of the chip assemblies, the contact surface of that chip assembly is a surface of the corresponding third intermediate plate.

7. The method as claimed in one of claims 5 or 6, wherein, at the end of the pressing of the contacting arrangement against the chip assemblies, each of the contacting elements which make an electrical contact with one of the contact surfaces forms a detachable electrical connection with that contact surface.

8. The method as claimed one of claims 5 to 7, wherein each of the first intermediate plates comprises a coefficient of linear thermal expansion of less than 8 ppm/K.

9. The method as claimed one of claims 5 to 8, wherein each of the first intermediate plates consists of or comprises molybdenum.

10. The method as claimed in one of the preceding claims, wherein
the semiconductor chip of each of the chip assemblies comprises a first chip metallization, a second chip metallization, and a semiconductor body disposed between the first chip metallization and the second chip metallization;
each of the chip assemblies comprises a second intermediate plate disposed between and electrically connected to both the second chip metallization of the respective chip assembly and the carrier.

11. The method as claimed in claim 10, wherein, at the end of the pressing of the contacting arrangement against the chip assemblies, each of the second chip metallizations is electrically connected to the carrier via one of the second intermediate plates.

12. The method as claimed in one of claims 10 or 11, wherein each of the second intermediate plates comprises a coefficient of linear thermal expansion of less than 8 ppm/K.

13. The method as claimed in one of the preceding claims, wherein at least the contacting elements of the contacting arrangement are soft-annealed prior to the pressing of the contacting arrangement against the chip assemblies.

14. The method as claimed in claim 13, wherein the soft annealing of at least the contacting elements of the contacting arrangement takes place by heating at least the contacting elements to temperatures of at least 650°C.

15. The method as claimed in one of the preceding claims, wherein
the semiconductor chip of each of the chip assemblies comprises a first chip metallization which is electrically connected with the contact surface of that chip assembly; and
at the end of the pressing of the contacting arrangement against the chip assemblies, for each of the chip assemblies the following applies:
for the first chip metallization of the semiconductor chip of the chip assembly, there is a projection plane in which an orthogonal projection of the first chip metallization is maximum and has a maximum projection area;
the ratio between the sum of the projection areas of the orthogonal projections of the interface surfaces between the contact surface of the chip assembly and all contacting elements that make an electrical contact with the first surface of the chip assembly and the maximum projection area is at least 0.1.
